# EUROPÄISCHE PATENTSCHRIFT

(11) **EP 1 238 433 B1**
(45) Veröffentlichungstag und Bekanntmachung des Hinweises auf die Patenterteilung: **08.07.2009**
(21) Anmeldenummer: 00979652.5
(22) Anmeldetag: 30.11.2000
(51) Int. Cl.: H01L 29/78, H01L 27/07, H01L 29/10

(54) **HALBLEITERSCHALTUNGSANORDNUNG UND VERFAHREN ZUR HERSTELLUNG**
SEMICONDUCTOR CIRCUIT ARRANGEMENT AND A METHOD FOR PRODUCING SAME
CIRCUIT A SEMI-CONDUCTEURS ET SON PROCEDE DE PRODUCTION

(30) Priorität: 30.11.1999 DE 19957532
(43) Veröffentlichungstag der Anmeldung: 11.09.2002
(73) Patentinhaber: Infineon Technologies AG, 81669 München (DE)
(72) Erfinder: HERZUM, Christian, 82343 Pöcking (DE); MÜLLER, Karl-Heinz, 84149 Velden (DE); KRUMBEIN, Ulrich, 83026 Rosenheim (DE)
(74) Vertreter: Zimmermann & Partner
(86) Internationale Anmeldenummer: PCT/EP2000/012051
(87) Internationale Veröffentlichungsnummer: WO 2001/041187

(56) Entgegenhaltungen:
- PATENT ABSTRACTS OF JAPAN vol. 007, no. 162 (E-187), 15. Juli 1983 (1983-07-15) -& JP 58 070572 A (HITACHI SEISAKUSHO KK), 27. April 1983 (1983-04-27)
- PATENT ABSTRACTS OF JAPAN vol. 013, no. 295 (E-783), 7. Juli 1989 (1989-07-07) -& JP 01 074760 A (HITACHI LTD;OTHERS: 01), 20. März 1989 (1989-03-20)
- PATENT ABSTRACTS OF JAPAN vol. 014, no. 082 (E-0889), 15. Februar 1990 (1990-02-15) -& JP 01 293565 A (HITACHI LTD;OTHERS: 01), 27. November 1989 (1989-11-27)
- ISAO YOSHIDA ET AL: "HIGHLY EFFICIENT UHG-BAND SI POWER MOSFET FOR RF POWER AMPLIFIERS" ELECTRONICS & COMMUNICATIONS IN JAPAN, PART II - ELECTRONICS,US,SCRIPTA TECHNICA. NEW YORK, Bd. 77, Nr. 4, 1. April 1994 (1994-04-01), Seiten 10-19, XP000485748 ISSN: 8756-663X
- YOSHIDA I: "2-GHZ SI POWER MOSFET TECHNOLOGY" INTERNATIONAL ELECTRON DEVICES MEETING,US,NEW YORK, NY: IEEE, 7. Dezember 1997 (1997-12-07), Seiten 51-54, XP000855743 ISBN: 0-7803-4101-5

## Beschreibung

Die Erfindung betrifft ein Verfahren zur Herstellung einer Halbleiterschaltungsanordnung gemäß Anspruch 1, sowie eine Halbleiterschaltungsanordnung gemäß Anspruch 4.

Als Beispiel für solche Halbleiterschaltungsanordnungen sind MOS-Tetroden und MOS-Pentoden mit mehreren Steueranschlüssen, insbesondere mit mindestens zwei Gate-Anschlüssen, nämlich einem Hochfrequenzgate und mindestens einem Regelgate bekannt, die entweder als Einzelbauelemente oder in hochintegrierter Form auf einem Halbleitersubstrat vermittels VLSI-Technolgieschritten gefertigt werden (VLSI = very large scale integration). JP 01 074 760 A beschreibt ein Halbleiterbauelement mit zwei Gateelektroden. Insbesondere bei einem Einsatz solcher MOS-Tetroden im Automobilbereich wird eine Eignung für Versorgungsspannungen von 12 V oder mehr gefordert. Die modernen CMOS-Prozessfertigungsverfahren sind in der Regel nur für die Fertigung von Halbleiterschaltungen für Versorgungsspannungen ≤ 5 V ausgelegt und eignen sich nicht ohne Weiteres zur Fertigung von Halbleiterschaltungen mit höheren Versorgungsspannungsbereichen. Wesentliche technologische Gründe hierfür liegen unter anderem in der zu geringen Gateoxiddikke, sowie in einer zu niedrigen Drain-Wannen-Durchbruchspannung bei den in modernen Standard-CMOS-Prozessen gefertigten Halbleiterschaltungen, die sich daher nicht ohne Weiteres zur Fertigung von MOS-Tetroden und MOS-Pentoden mit Versorgungsspannungen von 12 V oder mehr eignen.

Der Erfindung liegt die Aufgabe zugrunde, eine Halbleiterschaltungsanordnung mit zwei Gateanschlüssen, von denen einer ein Hochfrequenzgate ist, wie bei Tetroden oder Pentoden zur Verfügung zu stellen, die einen ersten Elektrodenanschluß besitzt, der Versorgungsspannungen von 12 V und mehr ermöglicht, sowie ein einfach durchzuführendes Verfahren zur Herstellung einer solchen Halbleiterschaltungsanordnung anzugeben.

Die Lösung der Aufgabe erfolgt durch das in Anspruch 1 angegebene Verfahren und die im Anspruch 4 angegebene Halbleiterschaltungsanordnung.

Bevorzugte Weiterbildungen der Erfindung ergeben sich aus den weiteren Unteransprüchen.

Weitere Merkmale, Vorteile und Zweckmäßigkeiten ergeben sich aus der nachfolgenden Beschreibung von Ausführungsbeispielen anhand der Zeichnung. Es zeigen:
- Figur 1: eine schematische Schnittansicht eines bevorzugten Ausführungsbeispieles der Erfindung; und
- Figur 2: eine vergrößerte Teilansicht des Ausführungsbeispieles der Erfindung.

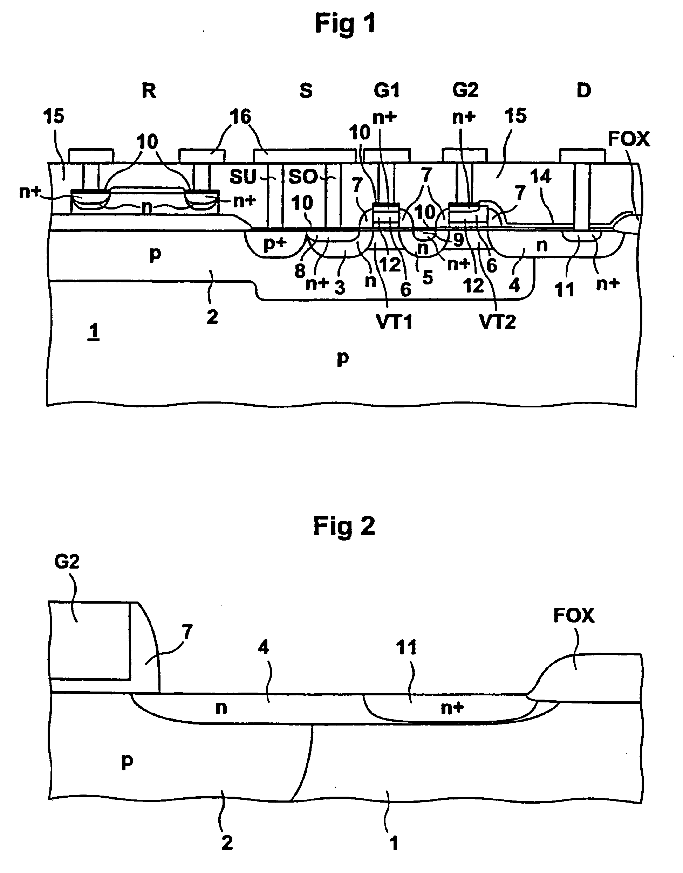

Die in Figur 1 gezeigte Halbleiterschaltungsanordnung umfasst eine Hochfrequenz-MOS-Tetrode als Schaltungselement einer integrierten Halbleiterschaltung nach dem besonders bevorzugten Ausführungsbeispiel der Erfindung. Sie ist nach einem Standard-CMOS-Prozessverfahren hergestellt, das als bekannt vorausgesetzt wird mit einem Halbleitersubstrat 1 aus p-leitendem Silizium (p-Dotierung = erster Leitfähigkeitstyp nach dieser Definition), wobei das integriert ausgebildete Schaltungselement wenigstens zwei Steueranschlüsse aus Polysilizium 6 auf Gate-Dielektrika 12, nämlich ein Hochfrequenzgate G1 mit einem Kanalbereich VT1 und ein durch das Zwischengebiet getrenntes Regelgate G2 mit einem Kanalbereich VT2, sowie einen ersten Elektrodenanschluss, nämlich einen Drainanschluss D, und einen zweiten Elektrodenanschluss, nämlich Sourceanschluss S (bestehend aus Source So und Substratanschluss Su) aufweist. Die unter den Polygates G1 und G2 angeordneten Kanalbereiche VT1 und VT2 können durch unterschiedliche Kanalimplantationen unterschiedlich dotiert sein, also auch etwa jeweils n- oder p-dotiert sein. Ein im Substrat 1 durch Dotierung gebildetes p-Gebiet 2 dient als pwell und das darin eingebettete p+-Gebiet als Substratanschluss. Die Bezugsziffern 3, 4 und 5 bezeichnen niedrig dotierte n-LDD-Gebiete (LDD = Lightly Doped Drain = schwach dotierter Drain) jeweils in Source-, Drain- und Zwischengebieten. Seitlich neben den Gates G1 und G2 sind Abstandhalter 7 (sogenannte "Spacer") aus einem geeigneten Dieelektrikum gebildet, die Bezugsziffern 8, 9, 11 bezeichnen n+ dotierte Kontaktgebiete in dem Sourceanschluss S, Drainanschluss D, sowie im Zwischengebiet zwischen den beiden Gates, wobei die Kontaktgebiete 8, 9 und 11 wie in der Darstellung ersichtlich jeweils von Source S und Zwischengebiet durch den Spacer 7 vom betreffenden Gate bzw. Kanal getrennt sind. Durch eine geeignete Einstellung mittels einer Maske ist ein größerer Abstand zwischen Gate G2 bzw. Kanal und Drainanschluss D eingestellt. Die Gateanschlüsse G1 und G2 werden teilweise oder auch vollständig mit n+ Dotierung implantiert. Die p-Wanne 2 endet im Gebiet zwischen dem Gate G2 und dem n+ dotierten Kontaktgebiet 11 des Drainanschlusses D.

R bezeichnet einen hochohmigen Widerstand.

Figur 2 zeigt in einer vergrößerten Teilansicht nähere Einzelheiten der Drain-Konstruktion nach der Erfindung, mit welcher eine Erhöhung der Drain-Wannen-Durchbruchspannung erzielt werden konnte. Der durch diese Konstruktion im Vergleich zur üblichen Standard-CMOS-Drain-Konstruktion erhöhte Anschlusswiderstand hat in den meisten Anwendungen keinerlei Nachteile, da der Ausgang der Tetroden z.B. in Tunern hochohmig angeschlossen wird. Neben der erhöhten Spannungsfestigkeit liefert diese Drain-Konstruktion auch eine geringe Ausgangskapazität Cₒₛₛ und damit Performancegewinne. Aus diesem Grund kann diese Drain-Konstruktion auch bei solchen Tetroden bevorzugt Verwendung finden, bei denen die Spannungsfestigkeit einer Standard-Drain-Konstruktion ausreicht, die aber in Hochfrequenzanwendungen eingesetzt werden. Die in Figur 2 näher dargestellte Drain-Konstruktion nach der Erfindung zeichnet sich nun dadurch aus, dass der p-leitende Wannenbereich 2 des zweiten Gateanschlusses G2 vor dem n⁺-dotierten Kontaktbereich 11 des Drainanschlusses D aufhört, welcher in dem in der Hauptoberfläche des Halbleitersubstrates 1 ausgebildeten Anschlussbereich (n-dotiertes LDD) 4 des zweiten Leitfähigkeitstyps n eingebettet ist.

### Bezugszeichenliste

- 1: Halbleitersubstrat
- 2: p-Gebiet
- 3, 4, 5: niedrig dotierte n-LDD-Gebiete
- 6: Polysilizium
- 7: Spacer
- 8, 9, 11: n+ dotierte Kontaktgebiete
- 10: Silizidbereiche
- 12: Gate-Dielektrikum
- 13: Gate-Poly
- 14: TEOS-Si02-Schicht
- G1: Hochfrequenzgate
- G2: Regelgate
- D: Drainanschluss
- S: Sourceanschluss
- VT1, VT2: Kanalbereiche

## Patentansprüche

1. Verfahren zur Herstellung einer Halbleiterschaltungsanordnung mit einem in einem Halbleitersubstrat (1) eines ersten Leitfähigkeitstyps integriert ausgebildeten Schaltungselement, welches ein Hochfrequenzgate (G1) und ein Regelgate (G2) sowie einen ersten (D) und zweiten Elektrodenanschluss (S) aufweist, wobei der erste Elektrodenanschluss (D) durch einen innerhalb einer in dem Halbleitersubstrat eingebetteten Anschlusswanne (4) eines zweiten, gegenüber dem ersten Leitfähigkeitstyp entgegengesetzten zweiten Leitfähigkeitstyps eingebetteten Unterwannenbereich (11) des zweiten Leitfähigkeitstyps, der jedoch gegenüber der Anschlusswanne höher dotiert ist, ausgebildet wird
**dadurch gekennzeichnet,**
**dass** der in der Hauptoberfläche des Halbleitersubstrates ausgebildete, dem ersten Elektrodenanschluss (D) zugeordnete Unterwannenbereich (11) des zweiten Leitfähigkeitstyps vor dem Wannenbereich (2) des ersten Leitfähigkeitstyps des Regelgates (G2) und der Wannenbereich (2) des Regelgates (G2) im Gebiet zwischen dem Regelgate (G2) und dem Unterwannenbereich (11) endet.

2. Verfahren nach Anspruch 1,
**dadurch gekennzeichnet,**
**dass** die Halbleiterschaltungsanordnung als diskretes Bauelement ausgebildet wird.

3. Verfahren nach Anspruch 1 oder 2,
**dadurch gekennzeichnet,**
**dass** die Halbleiterschaltungsanordnung eine Hochfrequenztransistor darstellt.

4. Halbleiterschaltungsanordnung mit einem in einem Halbleitersubstrat (1) eines ersten Leitfähigkeitstyps integriert ausgebildeten Schaltungselement, welches ein Hochfrequenzgate (G1) und ein Regelgate (G2) sowie einen ersten (D) und zweiten Elektrodenanschluss (S) aufweist, wobei der erste Elektrodenanschluss (D) durch einen innerhalb einer in dem Halbleitersubstrat eingebetteten Anschlusswanne (4) eines zweiten, gegenüber dem ersten Leitfähigkeitstyp entgegengesetzten zweiten Leitfähigkeitstyps eingebetteten Unterwannenbereich (11) des zweiten Leitfähigkeitstyps, der jedoch gegenüber der Anschlusswanne höher dotiert ist, ausgebildet ist, **dadurch gekennzeichnet,**
**dass** der in der Hauptoberfläche des Halbleitersubstrates ausgebildete, dem ersten Elektrodenanschluss (D) zugeordnete Unterwannenbereich (11) des zweiten Leitfähigkeitstyps vor dem Wannenbereich (2) des ersten Leitfähigkeitstyps des Regelgates (G2) und der Wannenbereich (2) des Regelgates (G2) im Gebiet zwischen dem Regelgate (G2) und dem Unterwannenbereich (11) endet.

5. Halbleiterschaltungsanordnung nach Anspruch 4,
**dadurch gekennzeichnet,**
**dass** die Halbleiterschaltungsanordnung als diskretes Bauelement ausgebildet ist.

6. Halbleiterschaltungsanordnung nach Anspruch 4 oder 5,
**dadurch gekennzeichnet,**
**dass** die Halbleiterschaltungsanordnung einen Hochfrequenztransistor darstellt.

## Claims

1. Method for producing a semiconductor circuit arrangement having a circuit element which is formed in an integrated manner in a semiconductor substrate (1) of a first conductivity type and has a high-frequency gate (G1) and a control gate (G2) and a first (D) and second electrode terminal (S), the first electrode terminal (D) being formed by a sub-well region (11) embedded within a terminal well (4) - embedded in the semiconductor substrate - of a second, second conductivity type opposite to the first conductivity type, said sub-well region being of the second conductivity type but being doped more highly than the terminal well,
**characterized**
**in that** the sub-well region (11) of the second conductivity type which is formed in the main surface of the semiconductor substrate and is assigned to the first electrode terminal (D) ends before the well region (2) of the first conductivity type of the control gate (G2), and the well region (2) of the control gate (G2) ends in the region between the control gate (G2) and the sub-well region (11).

2. Method according to Claim 1,
**characterized**
**in that** the semiconductor circuit arrangement is formed as a discrete component.

3. Method according to Claim 1 or 2,
**characterized**
**in that** the semiconductor circuit arrangement constitutes a high-frequency transistor.

4. Semiconductor circuit arrangement having a circuit element which is formed in an integrated manner in a semiconductor substrate (1) of a first conductivity type and has a high-frequency gate (G1) and a control gate (G2) and a first (D) and second electrode terminal (S), the first electrode terminal (D) being formed by, a sub-well region (11) embedded within a terminal well (4) - embedded in the semiconductor substrate - of a second, second conductivity type opposite to the first conductivity type, said sub-well region being of the second conductivity type but being doped more highly than the terminal well,
**characterized**
**in that** the sub-well region (11) of the second conductivity type which is formed in the main surface of the semiconductor substrate and is assigned to the first electrode terminal (D) ends before the well region (2) of the first conductivity type of the gate (G2), and the well region (2) of the control gate (G2) ends in the region between the control gate (G2) and the sub-well region (11).

5. Semiconductor circuit arrangement according to Claim 4,
**characterized**
**in that** the semiconductor circuit arrangement is formed as a discrete component.

6. Semiconductor circuit arrangement according to Claim 4 or 5,
**characterized**
**in that** the semiconductor circuit arrangement constitutes a high-frequency transistor.

## Revendications

1. Procédé de production d'un circuit à semi-conducteur comprenant un élément de circuit constitué de façon intégré dans un substrat (1) semi-conducteur d'un premier type de conductivité et ayant une grille (G1) de haute fréquence et une grille (G2) de régulation ainsi qu'une première borne (D) d'électrode et une deuxième borne (S) d'électrode, la première borne (D) d'électrode étant formée par une sous-zone (11) de caisson du deuxième type de conductivité incorporée au sein d'un caisson (4) de borne d'un deuxième type de conductivité opposé au premier type de conductivité incorporé dans le substrat semi-conducteur, la sous-zone de caisson étant toutefois plus dopée que le caisson de borne,
**caractérisé**
**en ce que** la sous-zone (11) de caisson du deuxième type de conductivité formée dans la surface principale du substrat semi-conducteur et associée à la première borne (D) d'électrode se termine avant la zone de caisson du premier type de conductivité de la grille (G2) de régulation et de la zone (2) de caisson de la grille (G2) de régulation dans la région comprise entre la grille (G2) de régulation et la sous-zone (11) de caisson.

2. Procédé suivant la revendication 1,
**caractérisé**
**en ce que** le circuit à semi-conducteur est constitué sous la forme d'un composant discret.

3. Procédé suivant la revendication 2,
**caractérisé**
**en ce que** le circuit à semi-conducteur constitue un transistor de haute fréquence.

4. Circuit à semi-conducteur ayant un élément de circuit intégré dans un substrat (1) semi-conducteur d'un premier type de conductivité et ayant une grille (G1) de haute fréquence et une grille (G2) de régulation ainsi qu'une première borne (D) d'électrode et une deuxième borne (S) d'électrode, la première borne (D) d'électrode étant formée par une sous-zone (11) de caisson du deuxième type de conductivité incorporée au sein d'un caisson (4) de borne d'un deuxième type de conductivité opposé au premier type de conductivité incorporé dans le substrat semi-conducteur, la sous-zone de caisson étant toutefois plus dopée que le caisson de borne.

5. Circuit à semi-conducteur suivant la revendication 4,
**caractérisé**
**en ce que** le circuit à semi-conducteur est constitué sous la forme d'un composant discret.

6. Circuit à semi-conducteur suivant la revendication 4 ou 5,
**caractérisé**
**en ce que** le circuit à semi-conducteur constitue un transistor de haute fréquence.
